# EUROPÄISCHE PATENTSCHRIFT

(11) **EP 1 374 405 B1**
(45) Veröffentlichungstag und Bekanntmachung des Hinweises auf die Patenterteilung: **03.11.2004**
(21) Anmeldenummer: 02726063.7
(22) Anmeldetag: 19.03.2002
(51) Int. Cl.: H03L 7/107, H03C 3/09

(54) **FREQUENZREGELSCHLEIFE ZUR FREQUENZMODULATION**
FREQUENCY CLOSED LOOP FOR FREQUENCY MODULATION
BOUCLE DE REGULATION DE FREQUENCE DESTINEE A LA MODULATION DE FREQUENCE

(30) Priorität: 20.03.2001 DE 10113530
(43) Veröffentlichungstag der Anmeldung: 02.01.2004
(73) Patentinhaber: Infineon Technologies AG, 81669 München (DE)
(72) Erfinder: MEVISSEN, Walter, 40227 Düsseldorf (DE); WAGNER, Elmar, 47269 Duisburg (DE)
(74) Vertreter: Epping Hermann & Fischer
(86) Internationale Anmeldenummer: PCT/DE2002/000992
(87) Internationale Veröffentlichungsnummer: WO 2002/075927

(56) Entgegenhaltungen:
- EP-A- 0 550 360
- EP-A- 0 844 739
- WO-A-98/51014

## Beschreibung

Die vorliegende Erfindung betrifft eine Frequenzregelschleife zur Frequenzmodulation.

Ein in der Nachrichtentechnik besonders wichtiger Anwendungsfall der Regelungstechnik ist die Nachlaufsynchronisation (Phase-Locked-Loop), PLL. Dabei wird die Frequenz eines Oszillators so eingestellt, daß sie mit der Frequenz eines Bezugsoszillators übereinstimmt. Als Oszillator werden üblicherweise spannungsgesteuerte Oszillatoren, Voltage Controlled Oscillators, VCO, eingesetzt.

Die Frequenzmodulation, Frequency Modulation, FM, ist eines der üblichen Modulationsverfahren bei der drahtlosen Nachrichtenübertragung. Dabei wird auf ein Signal mit einer Trägerfrequenz, beispielsweise eine Sinusschwingung, ein zu übertragendes Datensignal aufmoduliert. Bei der Modulation wird die Trägerfrequenz des Trägersignals moduliert.

Beispielsweise im digitalen Mobilfunk ist es üblich, in Zeitschlitzen zu senden. Ein hierdurch ermöglichtes Vielfachzugriffsverfahren wird als TDMA, Time Division Multiple Access, bezeichnet. Dabei senden verschiedene Mobilstationen jeweils in ihnen zugeordneten Zeitschlitzen.

Eine Frequenzmodulation mit geringem Aufwand ist mit den sogenannten Open-Loop-Systemen möglich, bei denen während einer Modulationsphase, das heißt während eines Sende-Zeitschlitzes, die Rückkopplung der Frequenzregelschleife aufgehoben und der Oszillator demnach während dieser Zeit freilaufend ist. Treten während der Modulations-Zeitschlitze jedoch Frequenzdrifts, beispielsweise temperaturbedingt, auf, so werden diese Frequenzfehler oder Frequenzdrifts der Trägerfrequenz eines vom Oszillator bereitgestellten Trägersignals nicht korrigiert oder ausgeregelt.

Demnach ist es erforderlich, den Oszillator in der Frequenzregelschleife so auszulegen, daß eine hohe Frequenzstabilität garantiert ist. Dies erfordert, daß mit großem Aufwand alle frequenzbestimmenden Größen des Oszillators während einer Sende- beziehungsweise Modulationsphase innerhalb geforderter Grenzen gehalten werden müssen.

Zur Lösung des Problems könnte in einer Frequenzregelschleife ein Schleifenfilter mit umschaltbaren Zeitkonstanten vorgesehen sein. Dabei könnte ein Schleifenfilter mit kleiner Zeitkonstante zu einer schnellen Regelung während eines Einschwingens der Regelschleife auf eine neue Frequenz und eine zweite, langsamere Zeitkonstante vorgesehen sein, welche eine langsame Regelung während eines Zeitschlitzes bereitstellt. Dabei tritt jedoch der Nachteil auf, daß zur Spannungsansteuerung eines spannungsgesteuerten Oszillators mit einer Abstimmspannung diese Spannung konstant zu halten ist. Andererseits sind Schleifenfilter üblicherweise mit zumindest einem kapazitiven Bauteil aufgebaut. Eine Veränderung der Filterkapazität bewirkt jedoch üblicherweise eine Veränderung der Steuerspannung oder Abstimmspannung des VCO.

Ein derartiger Gegenstand ist in dem Dokument EP 0 844 739 A1 gezeigt. Dort ist eine Phasenregelschleife vorgesehen, die einen Phasendetektor mit umschaltbarer Verstärkung zeigt. Weiterhin sind zwei Signalpfade gebildet, die mit je einem Schleifenfilter an einen Multiplexer angeschlossen sind. Dessen Ausgang ist an den Steuereingang eines VCO angeschlossen. Durch das Umschalten an Phasendetektor und Multiplexer können sich jedoch nachteilhafte Spannungssprünge am VCO-Eingang ergeben, die zu unerwünschten Frequenzsprüngen am Ausgang führen.

Aufgabe der vorliegenden Erfindung ist es, eine Frequenzregelschleife zur Frequenzmodulation anzugeben, welche einen einfachen Aufbau aufweist und bei der eine gute Frequenzstabilität während Sende-Zeitschlitzen erreicht ist.

Erfindungsgemäß wird die Aufgabe gelöst mit einer Frequenzregelschleife zur Frequenzmodulation, aufweisend
- einen gesteuerten Oszillator mit einem Abstimmeingang zur Frequenzabstimmung einer Trägerfrequenz, mit einem Modulationseingang zur Frequenzmodulation der Trägerfrequenz in einem Modulationszeitschlitz, mit einem Stabilisierungseingang zur Stabilisierung der Trägerfrequenz während des Modulationszeitschlitzes und mit einem Oszillatorausgang zur Bereitstellung eines Ausgangssignals mit der Trägerfrequenz,
- einen Phasen/Frequenzvergleicher mit einem Phasen/Frequenzvergleichereingang, der mit dem Oszillatorausgang gekoppelt ist, mit einem Referenzeingang, der mit einem Referenzfrequenz-Generator gekoppelt ist und mit einem Phasen/Frequenzvergleicherausgang,
- einen ersten Signalpfad zwischen Phasen/Frequenzvergleicherausgang und Abstimmeingang, der eine erste Ladungspumpenschaltung mit nachgeschaltetem ersten Schleifenfilter umfaßt,
- einen zweiten Signalpfad zwischen Phasen/Frequenzvergleicherausgang und Stabilisierungseingang, der eine zweite Ladungspumpenschaltung mit nachgeschaltetem zweiten Schleifenfilter umfaßt, und
- einen Schalter zum Deaktivieren des ersten Signalpfads während des Modulations-Zeitschlitzes, wobei der Modulationseingang und der Stabilisierungseingang bezüglich des Oszillatorausgangs eine gleiche VCO-Verstärkung aufweisen und die VCO-Verstärkung von Modulationseingang und Stabilisierungseingang bezüglich Oszillatorausgang klein gegenüber der VCO-Verstärkung des Abstimmeingangs bezüglich Oszillatorausgang ist.

Der gesteuerte Oszillator kann als spannungsgesteuerter Oszillator, VCO, als stromgesteuerter Oszillator, ICO oder als digital angesteuerter Oszillator, DCO ausgebildet sein.

Die beschriebene Frequenzregelschleife weist eine umschaltbare Verzweigung bereits vor der dem jeweiligen Schleifenfilter vorgeschalteten Ladungspumpe auf. Hierdurch ist bei einem Umschalten zwischen den Schleifenfiltern mit verschiedenen Zeitkonstanten keine Verfälschung der eingangsseitig am Oszillator anliegenden Abstimmspannung bewirkt.

Der Schalter zum Schalten zwischen den beiden Signalpfaden kann im ersten Signalpfad vorgesehen sein, so daß durch die beschriebene Einführung einer zweiten Ladungspumpenschaltung sowie eines zusätzlichen Steuereingangs des abstimmbaren Oszillators, nämlich des Stabilisierungseingangs, die mit dem zweiten Signalpfad gebildete, langsamere Regelschleife auch während einer Modulationsphase oder eines Modulationszeitschlitzes wirksam bleibt.

Der Schalter zum Umschalten zwischen erstem und zweitem Signalpfad ist vorzugsweise der Ladungspumpenschaltung im ersten Signalpfad vorzuschalten, so daß keine Spannungsänderung am Schleifenfilter durch Umschalten zwischen erstem und zweitem Signalpfad bewirkt ist.

Die beschriebene Frequenzregelschleife kann mit besonders geringem Zusatzaufwand implementiert sein, da übliche, spannungsgesteuerte Oszillatoren ohnehin neben dem Eingang zur Zuführung der Abstimmspannung, welche die Trägerfrequenz bestimmt, weitere Eingänge mit geringer Verstärkung haben können, denen ein oder mehrere Modulationssignale zuführbar sind.

Mit der beschriebenen Frequenzregelschleife kann vor einem Sende-Zeitschlitz beziehungsweise Modulations-Zeitschlitz durch Zuschalten des ersten Signalpfades eine schnelle Einregelung der Regelschleife auf eine gewünschte Trägerfrequenz erfolgen. Zu Beginn einer Modulationsphase oder eines Modulationszeitschlitzes wird der erste, schnell regelnde Signalpfad aus der Regelschleife herausgeschaltet, so daß lediglich der zweite Signalpfad eine wirksame Rückkopplung in der Frequenzregelschleife bewirkt, welche aufgrund der viel größeren Zeitkonstanten gegenüber der ersten Zeitkonstanten im ersten Schleifenfilter nur niederfrequente Anteile des Frequenzspektrums, das heißt die Trägerfrequenz zur Steuerung des VCO heranzieht, jedoch hochfrequente Anteile, welche die Modulationsdaten aufweisen oder durch ein Einschwingen der PLL bedingt sind, herausfiltert. Die Kondensatoren im zweiten Schleifenfilter werden dabei bevorzugt vor dem Modulations-Zeitschlitz auf eine geeignete konstante Spannung vorgeladen.

Die beschriebene Frequenzregelschleife ermöglicht eine deutliche Reduzierung der Anforderungen an die Frequenzstabilität des spannungsgesteuerten Oszillators, das heißt, sie ermöglicht ein einfacheres Oszillator-Design sowie kleinere, kostengünstigere Schleifenfilter et cetera.

In einer bevorzugten Ausführungsform der vorliegenden Erfindung weist das erste Schleifenfilter eine erste Zeitkonstante auf, welche klein gegenüber einer vom zweiten Schleifenfilter gebildeten zweiten Zeitkonstante ist.

Die kleine, erste Zeitkonstante im ersten Schleifenfilter ermöglicht eine schnelle Regelung im ersten Signalpfad und damit ein schnelles Einschwingen der Regelschleife auf eine neue Trägerfrequenz. Eine große Zeitkonstante im zweiten Schleifenfilter hingegen ermöglicht die bereits beschriebene, langsame Ausregelung während eines Sende- oder Modulationszeitschlitzes und damit eine verbesserte Stabilisierung der Trägerfrequenz bezüglich Drifts.

Gemäß der vorliegenden Erfindung weisen der Modulationseingang und der Stabilisierungseingang des Oszillators bezüglich des Oszillatorausgangs eine gleiche oder eine ähnliche, das heißt in der gleichen Größenordnung liegende, VCO-Verstärkung auf. Der Modulationseingang eines VCO weist üblicherweise eine verhältnismäßig kleine VCO-Verstärkung auf. Das heißt, daß eine eingangsseitig anliegende Spannungsänderung lediglich eine verhältnismäßig kleine Veränderung der Frequenz des Ausgangssignals des Oszillators bewirkt. Dies wird auch als Modulationshub bezeichnet.

Gemäß der vorliegenden Erfindung ist die VCO-Verstärkung von Modulationseingang und Stabilisierungseingang bezüglich Oszillatorausgang klein gegenüber der VCO-Verstärkung des Abstimmeingangs bezüglich Oszillatorausgang. Die Tatsache, daß der Modulationseingang gegenüber dem Abstimmeingang eines VCO eine kleine VCO-Verstärkung hat, ist üblich. Die Besonderheit ist, daß der Stabilisierungseingang ebenfalls eine kleine VCO-Verstärkung gegenüber dem Abstimmeingang des VCO aufweist, was im Zusammenhang mit den beiden den Eingängen vorgeschalteten, umschaltbaren Signalpfaden mit Ladungspumpenschaltungen und Schleifenfiltern eine gute Stabilisierung der Trägerfrequenz des VCO während einer Modulationsphase ermöglicht.

In einer weiteren, bevorzugten Ausführungsform der Erfindung ist ein Ausgangsschalter vorgesehen, der den Oszillatorausgang mit einem Schaltungsausgang verbindet zur Bereitstellung des Ausgangssignals des Oszillators am Schaltungsausgang während des Modulations-Zeitschlitzes. Beim bereits beschriebenen Zeitvielfachzugriffsverfahren TDMA wird üblicherweise gepulst gesendet in sogenannten Bursts oder Zeitschlitzen. Der Ausgangsschalter verbindet während eines Bursts oder Sende-Zeitschlitzes den Oszillatorausgang, an dem dann ein moduliertes Signal mit der Trägerfrequenz bereitsteht, mit dem Schaltungsausgang. Zwischen aufeinanderfolgenden Zeitschlitzen bleibt der Ausgangsschalter jedoch geöffnet; um Einschwingvorgänge nicht auf den Ausgang der Schaltung zu übertragen.

In einer weiteren, bevorzugten Ausführungsform der vorliegenden Erfindung ist eine Ansteuerschaltung zur Ansteuerung von Schalter und Ausgangsschalter vorgesehen. Die Ansteuerschaltung bewirkt ein zeitrichtiges Schalten des Schalters zum Umschalten zwischen erstem und zweitem Signalpfad sowie des Ausgangsschalters.

In einer weiteren, bevorzugten Ausführungsform der vorliegenden Erfindung ist zum Vor-Aufladen des zweiten Schleifenfilters während einer Einschwingphase des Oszillators und vor dem Modulationszeitschlitz eine Aufladeeinheit vorgesehen mit einem Eingang, dem eine Referenzspannung zuführbar ist und mit einem Ausgang, der mit dem zweiten Schleifenfilter verbunden ist. Das Vor-Aufladen des Schleifenfilters im zweiten Signalpfad ermöglicht eine besonders langsame Zeitkonstante des zweiten Schleifenfilters. Dabei kann das zweite Schleifenfilter beispielsweise auf einem Spannungs-Mittelwert vorgeladen sein.

In einer weiteren, bevorzugten Ausführungsform der vorliegenden Erfindung weist die Aufladeeinheit einen Steuereingang auf, der mit der Ansteuerschaltung zum Aktivieren der Aufladeeinheit während der Einschwingphase verbunden ist. Die Ansteuerschaltung kann dabei sicherstellen, daß das Vor-Aufladen des zweiten Schleifenfilters auf einen Mittelwert oder Referenzspannungswert während der Einschwingphase der Regelschleife auf eine neue Trägerfrequenz erfolgt und rechtzeitig vor einem Beginn eines Sende-Zeitschlitzes beendet ist.

In einer weiteren, bevorzugten Ausführungsform der vorliegenden Erfindung ist zur Kopplung des Oszillatorausgangs mit dem Phasen/Frequenzvergleichereingang ein erster Frequenzteiler und zur Kopplung des Referenzfrequenzgenerators mit dem Referenzeingang des Phasen/Frequenzvergleichers ein zweiter Frequenzteiler vorgesehen. Das Frequenzteilerverhältnis des zwischen Oszillatorausgang und Phasen/Frequenzvergleichereingang geschalteten Teilers, welcher einen ganzzahligen Teiler sowie einen Vorteiler umfassen kann, dient zur Kanalwahl des VCO, das heißt zum Einstellen einer gewünschten Trägerfrequenz, auf die der Oszillatoreingang einschwingen soll. Das Teilerverhältnis des Frequenzteilers am Referenzfrequenzgenerator kann ein festes Teilerverhältnis sein, welches den Einsatz einer sehr hochfrequenten Referenzquelle als Referenzsignal ermöglicht.

In einer weiteren, bevorzugten Ausführungsform der Erfindung weisen erstes und zweites Schleifenfilter je ein RC-Glied auf. Die RC-Glieder von erstem und zweitem Schleifenfilter können beispielsweise die bereits beschriebenen Zeitkonstanten von erstem und zweiten Schleifenfilter bilden sowie zudem eine Integration in der Frequenzregelschleife bewirken.

Weitere Einzelheiten der Erfindung sind Gegenstand der Unteransprüche.

Die Erfindung wird nachfolgend an einem Ausführungsbeispiel anhand der Zeichnungen näher erläutert. Es zeigen:
- Figur 1: ein Ausführungsbeispiel der erfindungsgemäßen Frequenzregelschleife anhand eines Blockschaltbilds und
- Figur 2: Signalverläufe ausgewählter Signale gemäß dem Blockschaltbild von Figur 1.

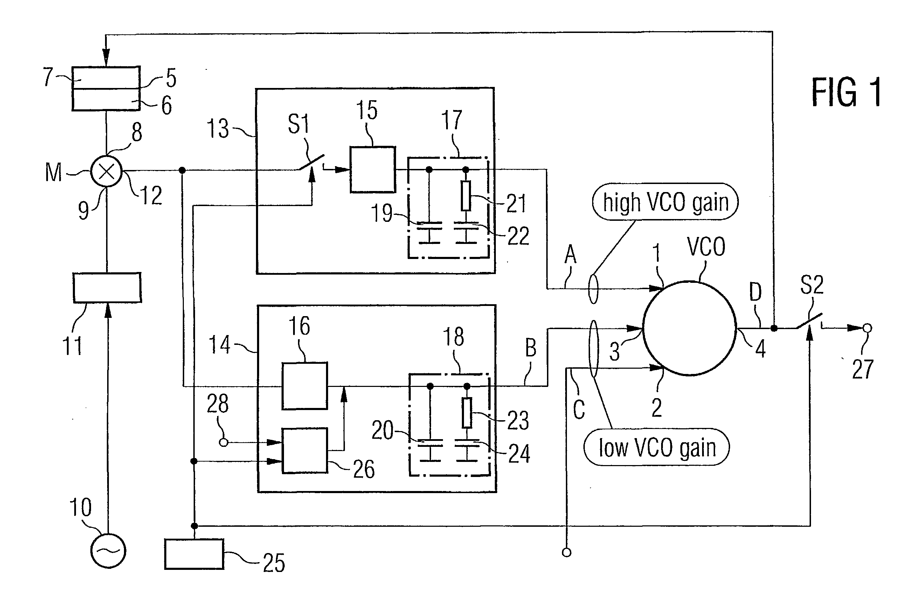

Figur 1 zeigt eine Frequenzregelschleife zur Frequenzmodulation mit einem spannungsgesteuerten Oszillator VCO, welcher drei Eingänge und einen Ausgang aufweist. Zudem ist ein Phasen/Frequenzvergleicher zum Vergleichen eines Oszillatorausgangssignals mit einem Referenzsignal vorgesehen, dessen Ausgang mit Oszillatoreingängen sowohl in einem ersten Signalpfad als auch in einem zweiten Signalpfad gekoppelt ist. Die Signalpfade umfassen jeweils eine Ladungspumpenschaltung sowie ein Schleifenfilter. Weiterhin sind Schalter zum Umschalten zwischen verschiedenen Betriebsarten vorgesehen.

Im einzelnen umfaßt der spannungsgesteuerte Oszillator VCO einen Abstimmeingang 1, einen Modulationseingang 2 und einen Stabilisierungseingang 3. Während dem Abstimmeingang 1 eine Abstimmspannung zum Abstimmen einer ausgangsseitigen Trägerfrequenz des VCO zuführbar ist, ist dem Modulationseingang eine Modulationsspannung zum Modulieren der Trägerfrequenz zuführbar und dem Stabilisierungseingang ist eine Stabilisierungsspannung während eines Modulations-Zeitschlitzes des VCO zuführbar. Der Oszillator VCO weist weiterhin einen Oszillatorausgang 4 auf, an dem ein Ausgangssignal mit der Trägerfrequenz, welches gegebenenfalls moduliert ist, bereitgestellt ist. Der Frequenzverlauf des Ausgangssignals ist mit D bezeichnet. An den Oszillatorausgang 4 ist ein Frequenzteiler 5, umfassend einen ganzzahligen Teiler 6 sowie einen Vorteiler 7, angeschlossen. Dieser ist an einen Phasen/Frequenzvergleichereingang 8 des Phasen/Frequenzvergleichers M gekoppelt. Mit dem Frequenzteiler 5 wird die Frequenz des Signals am Oszillatorausgang 4 heruntergeteilt. Mit dem einstellbaren Teilerverhältnis des Frequenzteilers 5 wird dabei der Kanal beziehungsweise die Trägerfrequenz, auf der gesendet werden soll, eingestellt. Weiterhin ist dem Phasen/Frequenzvergleicher M an einem Referenzeingang 9 ein von einem Referenzgenerator 10 bereitgestelltes und mit einem Teiler 11 heruntergeteiltes Referenzsignal zuführbar. Der Phasen/Frequenzvergleicher M stellt an seinem Phasen/Frequenzvergleicherausgang 12 ein Ausgangssignal bereit. Der Phasen/Frequenzvergleicherausgang 12 des Phasen/Frequenzvergleichers M ist zum einen über einen ersten Signalpfad 13 mit dem Abstimmeingang 1 des Oszillators VCO und zum anderen über einen zweiten Signalpfad 14 mit dem Stabilisierungseingang 3 des Oszillators VCO verbunden. Die beiden Signalpfade 13, 14 umfassen jeweils eine Ladungspumpenschaltung 15, 16 sowie ein nachgeschaltetes Schleifenfilter 17, 18. Die Schleifenfilter 17, 18 umfassen jeweils eine gegen Masse geschaltete Kapazität 19, 20 sowie eine gegen Masse geschaltete Serienschaltung aus einem Widerstand 21, 23 und einem Kondensator 22, 24. Selbstverständlich können die Schleifenfilter 17, 18, falls erforderlich, auch Filter höherer Ordnung als im vorliegenden, vereinfachten Ausführungsbeispiel gezeigt, sein.

Zusätzlich umfaßt der erste Signalpfad 13 einen Schalter S1, der eingangsseitig mit dem Phasen/Frequenzvergleicherausgang 12 und ausgangsseitig mit einem Eingang der Ladungspumpenschaltung 15 im ersten Signalpfad 13 verbunden ist. Mit dem ersten Schalter S1 ist der erste Signalpfad 13 im Regelkreis zu- oder abschaltbar. Am Oszillatorausgang 4 ist ein Ausgangsschalter S2 angeschlossen, der mit einem Steuereingang, ebenso wie der Schalter S1, mit einer Ansteuerschaltung 25 verbunden ist. Zusätzlich ist mit der Ansteuerschaltung 25 eine Aufladeeinheit 26 verbunden, welche in einer Einschwingphase des Regelkreises ein ihr ebenfalls eingangsseitig zuführbares Spannungs-Referenzsignal 28 ausgangsseitig als Spannungs-Mittelwert zum Aufladen des zweiten Schleifenfilters 18 bereitstellt.

Zur Bereitstellung einer schnellen Regelung zum Einschwingen des Regelkreises ist der erste Signalpfad 13 mit einem Schleifenfilter 17 mit kleiner Zeitkonstante ausgestattet. Zudem ist die erste Ladungspumpenschaltung 15 im ersten Signalpfad 13 für einen schnellen Regelvorgang ausgebildet. Zum schnellen Einschwingen des Regelkreises ist der Abstimmeingang 1 mit hoher VCO-Verstärkung ausgebildet, das heißt, daß bereits kleine Spannungsänderungen am Eingang 1 große Frequenzänderungen am Oszillatorausgang 4 bewirken. Der zweite Signalpfad 14 hingegen ist zu einer langsamen Regelung zur Vermeidung von Frequenzdrifts bei während einer Modulation geöffnetem Schalter S1 ausgelegt. Hierfür weist das zweite Schleifenfilter 18 eine sehr große Zeitkonstante gegenüber der Zeitkonstanten des ersten Schleifenfilters 17 auf. Zudem ist der Ausgang des zweiten Signalpfads 14 an einen VCO-Eingang mit geringer VCO-Verstärkung, nämlich den Stabilisierungseingang 3 des VCO angeschlossen. Bezüglich der VCO-Verstärkung ist der Stabilisierungseingang 3 gleich dem Modulationseingang 2 zum Zuführen eines Datensignals ausgebildet, mit dem eine Trägerfrequenz modulierbar ist. Die VCO-Verstärkung von Modulationseingang 2 und Stabilisierungseingang 3 ist demnach klein gegenüber der VCO-Verstärkung des Abstimmeingangs 1.

Die beschriebene Frequenzregelschleife verbindet die Vorteile des einfachen Aufbaus einer Open-Loop FM-Modulation mit der Möglichkeit, den VCO bezüglich Frequenzdrifts trotzdem zu stabilisieren. Hierfür wird die eigentliche, schnelle Regelschleife mit Schalter S1 geöffnet und es ist lediglich eine langsame Frequenzregelschleife zur Vermeidung von Frequenzdrifts am Ausgang des VCO wirksam. Demnach ist ein Oszillator mit geringen Anforderungen an die Frequenzstabilität einsetzbar, wodurch Chipfläche und Kosten einsparbar sind.

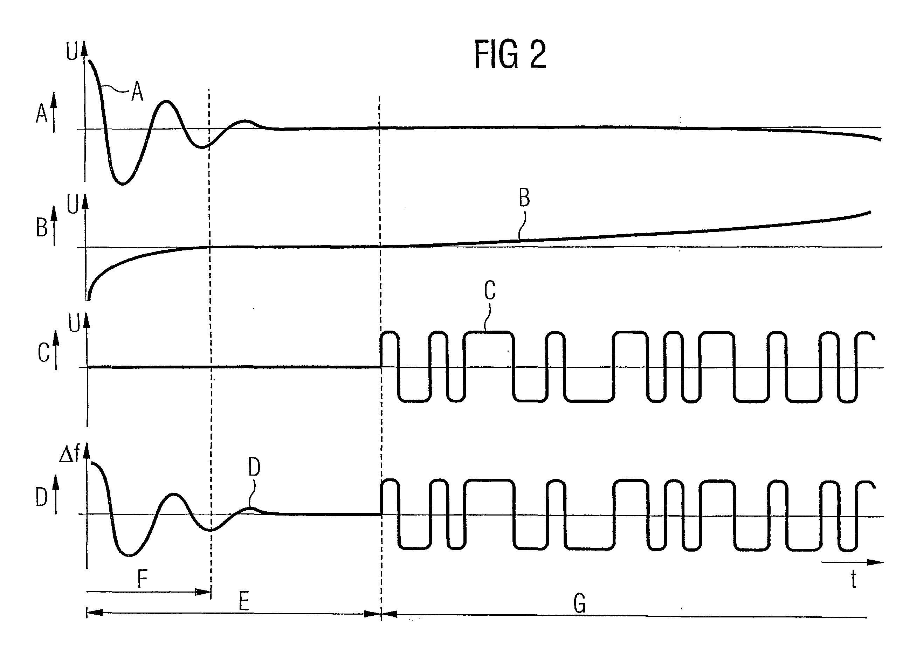

Zur weiteren Erläuterung der Funktionsweise des Blockschaltbilds gemäß Figur 1 sind in Figur 2 die Signalverläufe ausgewählter Signale gemäß Blockschaltbild von Figur 1 aufgetragen. Die Kurven zeigen jeweils Spannungs- beziehungsweise Frequenzverläufe über einer gemeinsamen Zeitachse, welche mit t bezeichnet ist. Im einzelnen zeigen die Kurven im Diagramm von Figur 2 die Abstimmspannung A, welche dem Abstimmeingang 1 des VCO zuführbar ist, die Stabilisierungsspannung B, welche dem Stabilisierungseingang 3 des VCO zuführbar ist sowie die Modulationsspannung C, welche dem Modulationseingang 2 des Oszillators VCO zuführbar ist. Die untere Kurve gemäß Figur 2 schließlich zeigt den zeitlichen Verlauf der Frequenz des am Oszillatorausgang 4 anliegenden Signals D. Der Zeitverlauf gemäß Figur 2 ist in eine Einschwingphase E und eine Modulationsphase G aufgeteilt. Während der Einschwingphase E schwingt die Frequenzregelschleife auf eine gewünschte Trägerfrequenz ein. Hierzu ist der Schalter S1 geschlossen. Das Einschwingen während der Einschwingphase ist sowohl anhand der Abstimmspannung A, als auch anhand der Oszillatorfrequenz D sichtbar. Während der Einschwingphase E ist der Schalter S1 geschlossen und Schalter S2 geöffnet. Während der Modulationsphase G wird mit dem Modulationssignal C die Trägerfrequenz des VCO moduliert, so daß ausgangsseitig ein Signal mit modulierter Trägerfrequenz ableitbar ist. Hierfür ist der Schalter S2 während der Modulationsphase G geschlossen und Schalter S1 geöffnet. Während der Modulationsphase G können Frequenzdrifts auftreten. Dies ist anhand der während Modulationsphase G zunehmenden Abweichung der Abstimmspannung A vom Wert im eingeschwungenen Zustand im Diagramm erkennbar. Da jedoch bei vorliegender Schaltung auch während der Modulationsphase G eine langsamere Frequenzregelung mit dem zweiten Signalpfad 14 gewährleistet ist, kompensiert eine dem Abweichen von Abstimmspannung A entgegenwirkende Stabilisierungsspannung B Drifteffekte, so daß insgesamt die Trägerfrequenz D am Ausgang des VCO konstant bleibt. Zu Beginn der Einschwingphase E ist zusätzlich eine Aufladung des Schleifenfilters 18 während einer Aufladephase F bewirkt. Dies ist anhand des Zeitverlaufs der Stabilisierungsspannung B während der Aufladephase F dem Diagramm entnehmbar. Der Verlauf der Oszillatorfrequenz F während der Modulationsphase G, das heißt während eines Sende-Zeitschlitzes, zeigt die erfolgreiche Stabilisierung der Trägerfrequenz des VCO während eines Bursts.

## Patentansprüche

1. Frequenzregelschleife zur Frequenzmodulation, aufweisend
- einen gesteuerten Oszillator (VCO) mit einem Abstimmeingang (1) zur Frequenzabstimmung einer Trägerfrequenz, mit einem Modulationseingang (2) zur Frequenzmodulation der Trägerfrequenz in einem Modulationszeitschlitz (G), mit einem Stabilisierungseingang (3) zur Stabilisierung der Trägerfrequenz während des Modulationszeitschlitzes (G) und mit einem Oszillatorausgang (4) zur Bereitstellung eines Ausgangssignals mit der Trägerfrequenz,
- einen Phasen/Frequenzvergleicher (M) mit einem Phasen/Frequenzvergleichereingang (8), der mit dem Oszillatorausgang (4) gekoppelt ist, mit einem Referenzeingang (9), der mit einem Referenzfrequenz-Generator (10) gekoppelt ist und mit einem Phasen/Frequenzvergleicherausgang (12),
- einen ersten Signalpfad (13) zwischen Phasen/Frequenzvergleicherausgang (12) und Abstimmeingang (1), der eine erste Ladungspumpenschaltung (15) mit nachgeschaltetem ersten Schleifenfilter (17) umfaßt,
- einen zweiten Signalpfad (14) zwischen Phasen/Frequenzvergleicherausgang (12) und Stabilisierungseingang (3), der eine zweite Ladungspumpenschaltung (16) mit nachgeschaltetem zweiten Schleifenfilter (18) umfaßt, und
- einen Schalter (S1) zum Deaktivieren des ersten Signalpfads (13) während des Modulations-Zeitschlitzes (G),
**dadurch gekennzeichnet, daß**
der Modulationseingang (2) und der Stabilisierungseingang (3) bezüglich des Oszillatorausgangs (4) eine gleiche VCO-Verstärkung aufweisen und die VCO-Verstärkung von Modulationseingang (2) und Stabilisierungseingang (3) bezüglich Oszillatorausgang (4) klein gegenüber der VCO-Verstärkung des Abstimmeingangs (1) bezüglich Oszillatorausgang (4) ist.

2. Frequenzregelschleife nach Anspruch 1,
**dadurch gekennzeichnet, daß**
das erste Schleifenfilter (13) eine erste Zeitkonstante aufweist, welche klein gegenüber einer vom zweiten Schleifenfilter (14) gebildeten Zeitkonstante ist zur Bildung einer langsameren Regelung im zweiten Signalpfad (14) gegenüber dem ersten Signalpfad (13).

3. Frequenzregelschleife nach Anspruch 1 oder 2,
**dadurch gekennzeichnet, daß**
ein Ausgangsschalter (S2) vorgesehen ist, der den Oszillatorausgang (4) mit einem Schaltungsausgang (27) verbindet zur Bereitstellung des Ausgangssignals des Oszillators (VCO) am Schaltungsausgang (27) während des Modulationszeitschlitzes (G).

4. Frequenzregelschleife nach Anspruch 3,
**dadurch gekennzeichnet, daß**
eine Ansteuerschaltung (25) zur Ansteuerung von Schalter (S1) und Ausgangsschalter (S2) vorgesehen ist.

5. Frequenzregelschleife nach einem der Ansprüche 1 bis 4,
**dadurch gekennzeichnet, daß**
zu einem Vor-Aufladen des zweiten Schleifenfilters (14) während einer Einschwingphase (E) des Oszillators (VCO) und vor dem Modulations-Zeitschlitz (G) eine Aufladeeinheit (26) vorgesehen ist mit einem Eingang, dem eine Referenzspannung (28) zuführbar ist und mit einem Ausgang, der mit dem zweiten Schleifenfilter (18) verbunden ist.

6. Frequenzregelschleife nach Anspruch 4 und 5,
**dadurch gekennzeichnet, daß**
die Aufladeeinheit (26) einen Steuereingang aufweist, der mit der Ansteuerschaltung (25) zum Aktivieren der Aufladeeinheit (26) während einer Aufladephase (F) verbunden ist.

7. Frequenzregelschleife nach einem der Ansprüche 1 bis 6,
**dadurch gekennzeichnet, daß**
zur Kopplung des Oszillatorausgangs (4) mit dem Phasen/Frequenzvergleichereingang (8) ein erster Frequenzteiler (5) und/oder zur Kopplung des Referenzfrequenzgenerators (10) mit dem Referenzeingang (9) des Phasen/Frequenzvergleichers (M) ein zweiter Frequenzteiler (11) vorgesehen ist.

8. Frequenzregelschleife nach einem der Ansprüche 1 bis 7,
**dadurch gekennzeichnet, daß**
erstes und zweites Schleifenfilter je ein RC-Glied (21, 22; 23, 24) umfassen.

## Claims

1. Frequency locked loop for frequency modulation, having
- a controlled oscillator (VCO) with a tuning input (1) for frequency tuning a carrier frequency, with a modulation input (2) for frequency modulating the carrier frequency in a modulation timeslot (G), with a stabilization input (3) for stabilizing the carrier frequency during the modulation timeslot (G), and with an oscillator output (4) for providing an output signal at the carrier frequency,
- a phase/frequency comparator (M) with a phase/frequency comparator input (8) which is coupled to the oscillator output (4), with a reference input (9) which is coupled to a reference frequency generator (10), and with a phase/frequency comparator output (12),
- a first signal path (13) between the phase/frequency comparator output (12) and the tuning input (1), which comprises a first charge pump circuit (15) with a downstream first loop filter (17),
- a second signal path (14) between the phase/frequency comparator output (12) and the stabilization input (3), which comprises a second charge pump circuit (16) with a downstream second loop filter (18), and
- a switch (S1) for deactivating the first signal path (13) during the modulation timeslot (G),
**characterized in that**
the modulation input (2) and the stabilization input (3) have an identical VCO gain with respect to the oscillator output (4), and the VCO gain of the modulation input (2) and of the stabilization input (3) with respect to the oscillator output (4) is lower than the VCO gain of the tuning input (1) with respect to the oscillator output (4).

2. Frequency locked loop according to Claim 1,
**characterized in that**
the first loop filter (13) has a first time constant, which is smaller than a time constant formed by the second loop filter (14), in order to form slower control in the second signal path (14) than in the first signal path (13).

3. Frequency locked loop according to Claim 1 or 2,
**characterized in that**
an output switch (S2) is provided which connects the oscillator output (4) to a circuit output (27) in order to provide the output signal from the oscillator (VCO) at the circuit output (27) during the modulation timeslot (G).

4. Frequency locked loop according to Claim 3,
**characterized in that**
an actuation circuit (25) is provided in order to actuate the switch (S1) and the output switch (S2).

5. Frequency locked loop according to one of Claims 1 to 4,
**characterized in that**
for the purpose of precharging the second loop filter (14) during a transient phase (E) in the oscillator (VCO) and before the modulation timeslot (G) a charging unit (26) is provided which has an input, to which a reference voltage (28) can be supplied, and which has an output, which is connected to the second loop filter (18).

6. Frequency locked loop according to Claims 4 and 5,
**characterized in that**
the charging unit (26) has a control input which is connected to the actuation circuit (25) in order to activate the charging unit (26) during a charging phase (F).

7. Frequency locked loop according to one of Claims 1 to 6,
**characterized in that**
for the purpose of coupling the oscillator output (4) to the phase/frequency comparator input (8) a first frequency divider (5) is provided and/or for the purpose of coupling the reference frequency generator (10) to the reference input (9) of the phase/frequency comparator (M) a second frequency divider (11) is provided.

8. Frequency locked loop according to one of Claims 1 to 7,
**characterized in that**
the first and second loop filters each comprise an RC element (21, 22; 23, 24).

## Revendications

1. Boucle de régulation de fréquence pour la modulation de fréquence comprenant :
- un oscillateur (VCO) commandé, ayant une entrée (1) d'accord pour l'accord en fréquence d'une fréquence porteuse, une entrée (2) de modulation pour la modulation en fréquence de la fréquence porteuse dans un créneau (G) temporel de modulation, une entrée (3) de stabilisation de la fréquence porteuse pendant le créneau (G) temporel de modulation et une sortie (4) d'oscillateur de mise à disposition d'un signal de sortie ayant la fréquence porteuse,
- un comparateur (M) de phase/fréquence comprenant une entrée (8) de comparateur de phase/fréquence, qui est couplée à la sortie (4) de l'oscillateur, une entrée (9) de référence, qui est couplée à un générateur (10) de fréquence de référence et une sortie (12) de comparateur de phase/fréquence,
- un premier trajet (13) de signal entre la sortie (12) du comparateur de phase/fréquence et l'entrée (1) d'accord, qui comporte un premier circuit (15) de pompe de charge ayant un premier filtre (17) à boucle en aval,
- un deuxième trajet (14) de signal entre la sortie (12) de comparateur de phase/fréquence et l'entrée (3) de stabilisation, qui comporte un deuxième circuit (16) de pompe de charge ayant un deuxième filtre (18) à boucle en aval et,
- un commutateur (S1 ) pour désactiver le premier trajet (13) de signal pendant le créneau (G) temporel de modulation, **caractérisé en ce que** l'entrée (2) de modulation et l'entrée (3) de stabilisation ont, par rapport à la sortie (4) de l'oscillateur, une même amplification VCO et l'amplification VCO de l'entrée (2) de modulation et de l'entrée (3) de stabilisation par rapport à la sortie (4) de l'oscillateur est petite par rapport à l'amplification VCO de l'entrée (1) d'accord par rapport à la sortie (4) de l'oscillateur.

2. Boucle de régulation de fréquence suivant la revendication 1,
**caractérisée en ce que** le premier filtre (13) à boucle a une première constante de temps qui est petite par rapport à une constante de temps formée par le deuxième filtre (14) à boucle, pour former une régulation plus lente dans le deuxième trajet (14) de signal que dans le premier trajet (13) de signal.

3. Boucle de régulation de fréquence suivant la revendication 1 ou 2,
**caractérisée en ce qu'**il est prévu un interrupteur (S2) de sortie, qui relie la sortie (4) de l'oscillateur à une sortie (27) de circuit pour mettre à disposition le signal de sortie de l'oscillateur VCO à la sortie (27) du circuit pendant le créneau (G) temporel de modulation.

4. Boucle de régulation de fréquence suivant la revendication 3,
**caractérisée en ce qu'**il est prévu un circuit (25) de commande du commutateur (S1) et de l'interrupteur (S2) de sortie.

5. Boucle de régulation de fréquence suivant l'une des revendications 1 à 4,
**caractérisée en ce qu'**il est prévu, pour un préchargement du deuxième filtre (14) à boucle pendant une phase (E) transitoire de monter en oscillation de l'oscillateur (VCO) et avant le créneau (G) temporel de modulation, une unité (26) de charge ayant une entrée à laquelle peut être appliquée une tension (28) de référence et ayant une sortie qui est reliée au deuxième filtre (18) à boucle.

6. Boucle de régulation de fréquence suivant la revendication 4 et 5,
**caractérisée en ce que** l'unité (6) de charge a une entrée de commande, qui est reliée au circuit (25) de commande pour activer l'unité (26) de charge pendant une phase (F) de charge.

7. Boucle de régulation de fréquence suivant l'une des revendications 1 à 6,
**caractérisée en ce que**, pour le couplage de la sortie (4) de l'oscillateur à l'entrée (8) de comparateur de phase/fréquence, il est prévu un premier diviseur (5) de fréquence et/ou, pour le couplage du générateur (10) de fréquence de référence à l'entrée (9) de référence du comparateur (M) de phase/fréquence, un deuxième diviseur (11) de fréquence.

8. Boucle de régulation de fréquence suivant l'une des revendications 1 à 7,
**caractérisée en ce que** le premier et le deuxième filtres à boucle comprennent chacun un élément (21, 22, 23, 24) RC.
